Europäisches Patentamt

European Patent Office

Office européen des brevets

(11) Veröffentlichungsnummer: **0 323 638**

**A1**

(12) **EUROPÄISCHE PATENTANMELDUNG**

(21) Anmeldenummer: 88121833.3

(22) Anmeldetag: 29.12.88

(51) Int. Cl.⁴: **F02M 51/06 , H01L 41/08**

(30) Priorität: 07.01.88 DE 3800203

(43) Veröffentlichungstag der Anmeldung:
**12.07.89 Patentblatt 89/28**

(84) Benannte Vertragsstaaten:
**DE FR GB IT**

(71) Anmelder: **Atlas Fahrzeugtechnik GmbH**
**Gewerbestrasse 20**
**D-5980 Werdohl(DE)**

(72) Erfinder: **Brandner, Burkhard**
**Bornstrasse 2**
**D-5980 Werdohl(DE)**
Erfinder: **Wenzlik, Klaus**
**Schlehdorn 7**
**D-5860 Iserlohn(DE)**

(74) Vertreter: **Hassler, Werner, Dr.**
**Patentanwälte Dr. W. Hassler, Dipl.-Chem. F.**
**Schrumpf Postfach 1704**
**D-5880 Lüdenscheid(DE)**

(54) **Kraftstoffeinspritzventil.**

㊡ Ein Kraftstoffeinspritzventil mit einem piezokeramischen Ventilkörper umfassend aufeinander geschichtete Keramikplatten (14) mit Spannungszuführungen zu jeder Keramikplatte, wobei jede Keramikplatte auf einer Trägerplatte (13) sitzt, wobei jeweils zwischen benachbarten Träger-Keramikplatten (14) Leiterfolie (16) angeordnet ist und jeweils Anschlußfahnen (26, 27) der Leiterfolien mit verschiedenen Kontakten verbunden sind. Das technische Problem ist die Vergrößerung des Stellweges eines piezokeramischen Ventils bei Verwendung von Biegeschwingern. Träger-Keramikplatten entgegengesetzer Polarität sind jeweils paarweise aufeinander geschichtet.

EP 0 323 638 A1

Fig. 4

## Kraftstoffeinspritzventil

Die Erfindung betrifft ein Kraftstoffeinspritzventil mit einem piezokeramischen Ventilkörper umfassend aufeinander geschichtete Keramikplatten mit Spannungszuführungen zu jeder Keramikplatte, wobei jede Keramikplatte auf einer Trägerplatte sitzt, wobei jeweils zwischen benachbarten Träger-Keramikplatten eine Leiterfolie angeordnet ist und jeweils Anschlußfahnen der Leiterfolien mit verschiedenen Kontakten verbunden sind.

Ein derartiges Kraftstoffeinspritzventil ist aus der DE-OS 35 32 660 bekannt. Dort sind Biegeschwinger mit gleicher Polarität und damit gleichem Stellweg aufeinander geschichtet, um die Stellkraft zu erhöhen. Da sich die einzelnen Biegeschwinger in gleicher Weise bei der Erregung verformen, liegen die Biegeschwinger eines Pakets bei der Verformung im wesentlichen bündig aneinander an, so daß keine Schwierigkeiten auftreten.

Die DE-OS 24 02 085 zeigt eine Anordnung von Längsschwingern. Dabei addieren sich die Verstellwege der einzelnen Längsschwinger, so daß eine Wegvergrößerung durch die Anordnung mehrerer Längsschwinger erzielbar ist. Da die Längsschwinger im wesentlichen stumpf aneinander anliegen, ergeben sich auch hier keine Schwierigkeiten bei der Anordnung.

Aufgabe der Erfindung ist die Vergrößerung des Stellweges eines piezokeramischen Ventils bei Verwendung von Biegeschwingern.

Diese Aufgabe wird nach der Erfindung dadurch gelöst, daß jeweils paarweise Träger-Keramikplatten entgegengesetzter Polarität aufeinander geschichtet sind.

Die Erfindung unterscheidet sich insofern vom Stand der Technik, als jeweils die Träger-Keramikplatten eines Paares bei der Erregung entgegengesetzt zueinander verformt werden, so daß sich hieraus eine Wegvergrößerung ergibt.

Wenn der Stellweg am Rand der Platten erzielt werden soll, ist vorgesehen, daß die Träger-Keramikplatten eines jeden Paares bei Anlegung einer Erregungsspannung konvex zueinander gekrümmt sind und sich im Mittelbereich unmittelbar aneinander abstützen.

Zur Erzielung einer sicheren und dauerhaften Abstützung ist vorgesehen, daß zwischen den Träger-Keramikplatten eines jeden Paares ein Metallring angeordnet ist, auf dem sich die Träger-Keramikplatten einerseits abstützen und der andererseits einen Anschlußkontakt für das Träger-Keramikplattenpaar aufweist. Der Metallring wird auch langem Gebrauch im Gegensatz zu einer Folie nicht abgenutzt.

Eine variable Abstützung zur Übertragung der Verstellung erzielt man dadurch, daß die Randbereiche der Träger-Keramikplatten jeweils auf einer Platte abgestützt sind, die die Ventilbewegung auf den Verschlußkörper überträgt.

Wenn andererseits der Stellweg im Mittelbereich der Platten erzielt werden soll, ist vorgesehen, daß die Träger-Keramikplatten eines jeden Paares bei Anlegung einer Erregungsspannung konkav zueinander gekrümmt sind und sich jeweils am Rand gegeneinander abstützen.

Ausführungsformen der Erfindung werden im Folgenden unter Bezugnahme auf die anliegenden Zeichnungen erläutert, in denen darstellen:

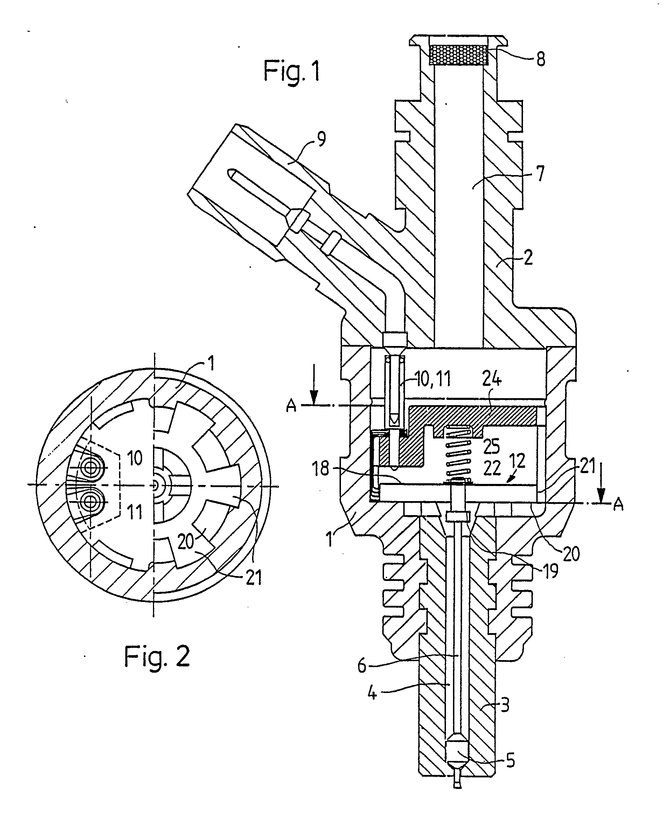

Fig. 1 einen Axialschnitt durch ein Kraftstoffeinspritzventil nach der Erfindung,

Fig. 2 einen Schnitt nach der Linie A-A in Fig. 1,

Fig. 3 in vergrößertem Maßstab einen Schnitt durch den Plattenstapel einer ersten Ausführungsform der Erfindung,

Fig. 4 einen entsprechender Schnitt durch den Plattenstapel in betätigtem Zustand,

Fig. 5 einen Schnitt durch den Plattenstapel einer weiteren Ausführungsform der Erfindung und

Fig. 6 einen Schnitt durch den Plattenstapel in betätigtem Zustand.

Das Kraftstoffeinspritzventil umfaßt ein Ventilgehäuse 1 mit einem Deckel 2 und einer Einspritzdüse 3. Innerhalb der Einspritzdüse 3 befindet sich ein Einspritzkanal 4, der durch einen an einem Ventilschaft 6 sitzenden Verschlußkörper 3 abgeschlossen ist. Innerhalb des Deckels befindet sich ein Kraftstoffzufuhrkanal 7 und ein Filterkörper 8. Außerdem ist eine Steckverbindung 9 mit zwei Kontaktstiften 10, 11 vorgesehen.

Innerhalb des Ventilgehäuses 1 befindet sich ein piezokeramisches Plattenpaket 12. Dasselbe ist aus mehreren plattenförmigen Biegeschwingern aufgebaut.

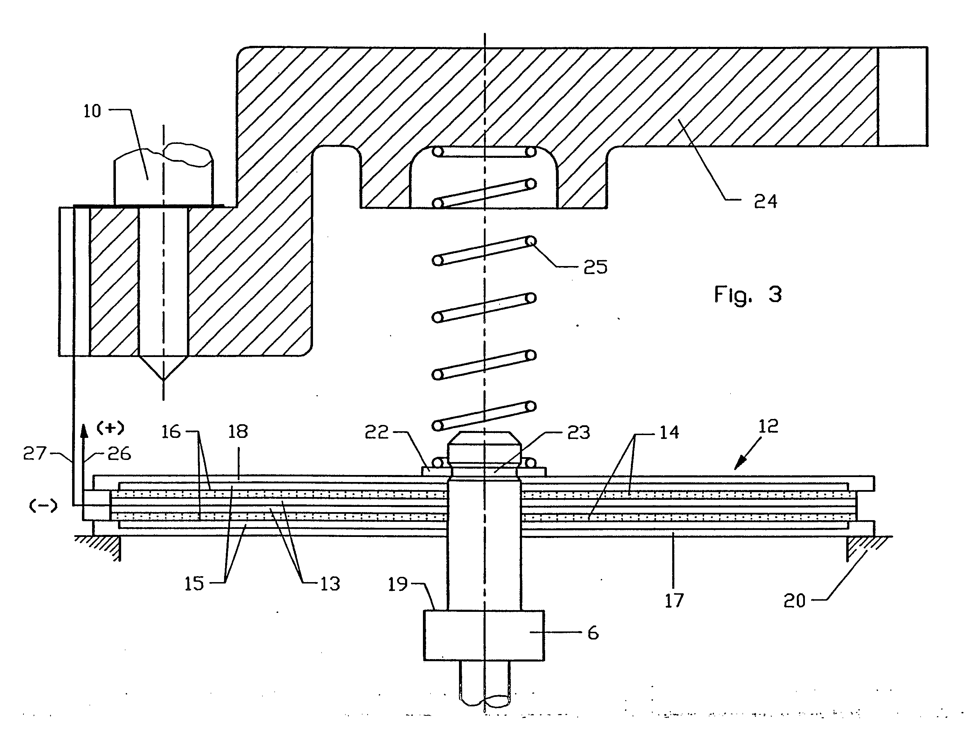

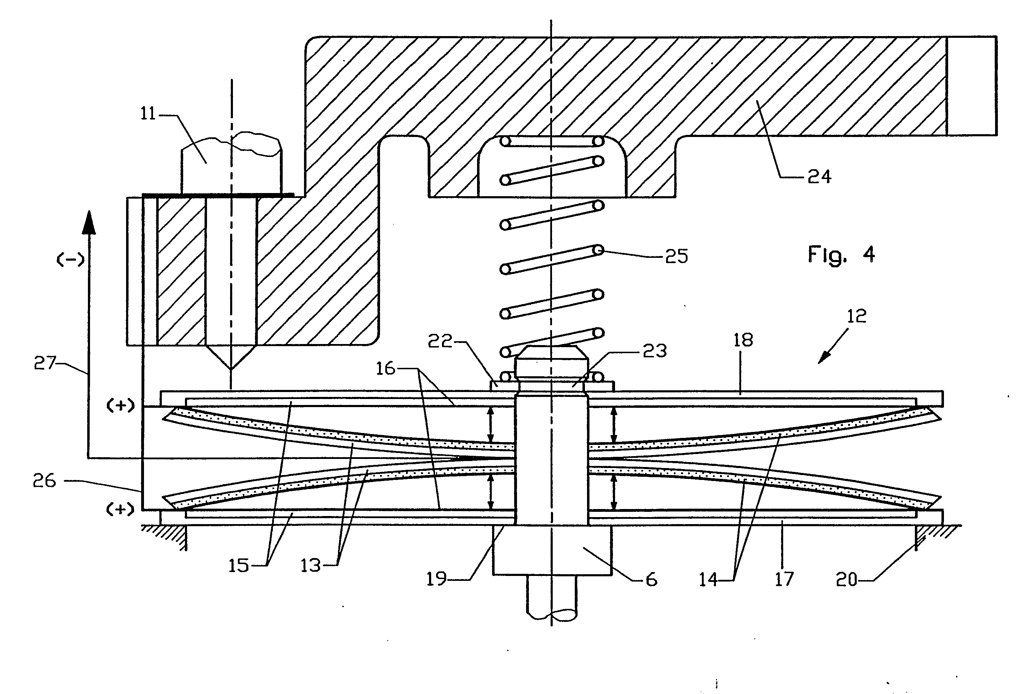

Die Fig. 3 und 4 zeigen eine erste Ausführungsform, bei der die Biegeschwinger bei der Biegebewegung im zentralen Bereich aneinander anliegen. Jeder Biegeschwinger umfaßt eine metallische Trägerplatte 13, die jeweils eine Keramikplatte 14 trägt. Die Keramikplatte 14 ist mit der jeweiligen Trägerplatte 13 nach der herkömmlichen Technik fest verbunden. Die Trägerplatten 13 liegen jeweils aneinander an. Zwischen den Trägerplatten 13 befindet sich eine Leiterfolie 16. Jede Keramikplatte 14 liegt auf einer Leiterfolie 16 auf, die an einer Platte 17 bzw. 18 abgestützt ist.

Die Platte 17 liegt einerseits auf einem Bund 19 des Ventilschaftes 6 und andererseits auf einem Bund 20 des Ventilgehäuses 1 auf. Im Bereich des Bundes 20 befinden sich Durchtrittskanäle 21 für den Kraftstoff. Auf der Platte 18 stützt sich eine Federscheibe 22 ab, die in einer Rinne 23 des Ventilschaftes 6 gehalten ist. Diese Federscheibe 22 hält das Plattenpaket 12 zusammen, damit eine ausreichende elektrische Kontaktierung zwischen den Leiterfolien 6 und den Trägerplatten 13 bzw. Keramikplatten 14 gewährleistet ist.

Innerhalb des Ventilgehäuses 1 ist eine Abstützplatte 24 angeordnet, an der sich eine Schraubendruckfeder 25 abstützt. Diese Schraubendruckfeder 25 liegt ebenfalls an dem Plattenpaket 12 an und stellt den Schließdruck für den Verschlußkörper 5 bereit.

Die Leiterfolien 16 einer Spannungspolarität, die mit den Keramikplatten Kontakt haben, sind in Anschlußfahnen 26 verlängert. Die Leiterfolie 16 der anderen Spannungspolarität, die an den Trägerplatten 13 anliegt, ist mit einer Anschlußfahne 27 verbunden und auf dem Kontaktstift 11 der entsprechenden Polarität aufgesetzt. Dadurch ist eine sichere leitende Verbindung gewährleistet. Entsprechendes gilt für die Leiterfolien 16 und die Anschlußfahnen 27 der anderen Spannungspolarität. Der Kontaktstift 11 ist in der Abstützplatte 24 befestigt und fixiert. Die Anschlußfahnen 26 und 27 sind in Umfangsrichtung gegeneinander versetzt.

Anstelle einer Leiterfolie kann man auch einen Metallring zwischen den Träger-Keramikplatten anordnen. Der Metallring braucht die Träger-Keramikplatten nur im Mittelbereich abzustützen, da sich die Träger-Keramikplatten bei Erregung voneinander wegwölben. Es ist dann immer eine ausreichende Kontaktierung gewährleistet.

Fig. 3 zeigt den Grundzustand des Ventils, in dem die Keramikplatten nicht erregt sind. Die Keramikplatten 14 sind also eben, so daß der Ventilschaft 6 durch die Druckfeder 25 gestreckt ist. Das Kraftstoffeinspritzventil ist infolgedessen gesperrt.

Fig. 4 zeigt den Erregungszustand des Ventils. Durch die anliegende Spannung sind die Keramikplatten jeweils mit konvexer Krümmung gebogen und stützen sich im Mittelbereich aneinander ab. Die Metallplatte 17 stützt sich auf der Schulter 20 auf. Der Ventilschaft 6 ist angehoben, so daß das Kraftstoffeinspritzventil geöffnet ist. Jede Keramikplatte liefert einen gleichen Durchbiegungsbetrag und damit Wegbetrag für die Öffnungsbewegung des Ventilschaftes. Infolgedessen erhält man mit zwei Keramikplatten einen doppelten Öffnungsweg gegenüber dem durch eine Keramikplatte bedingten Weg.

Man kann in der beschriebenen Weise noch mehrere Keramikplatten aufeinander schichten, so daß man dadurch eine erhebliche Wegvergrößerung erhält.

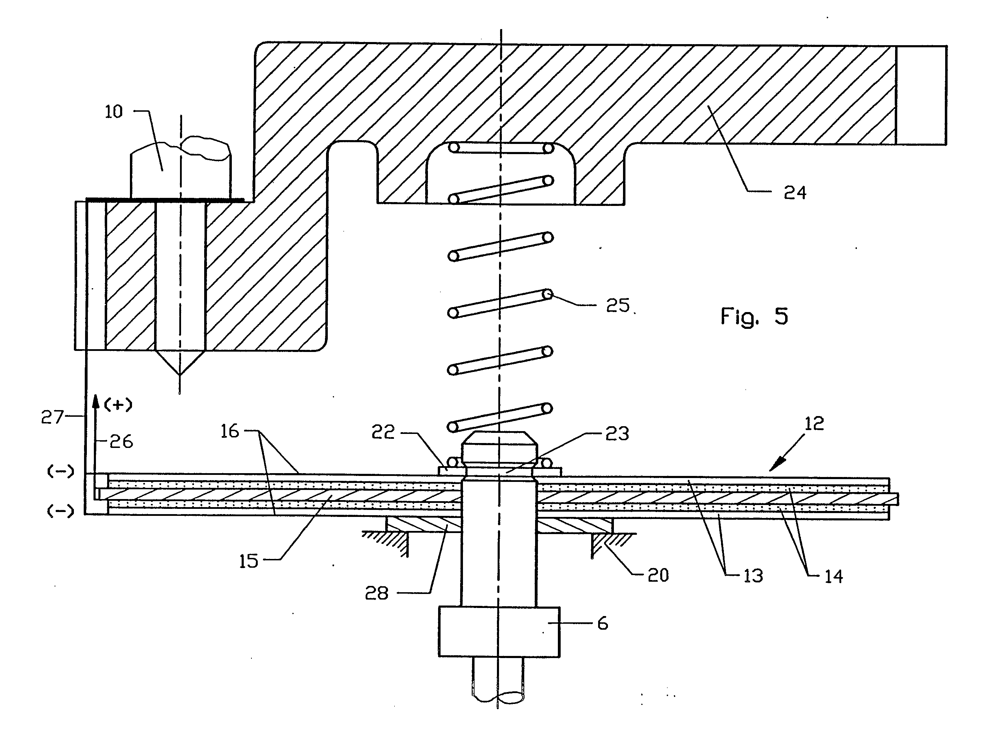

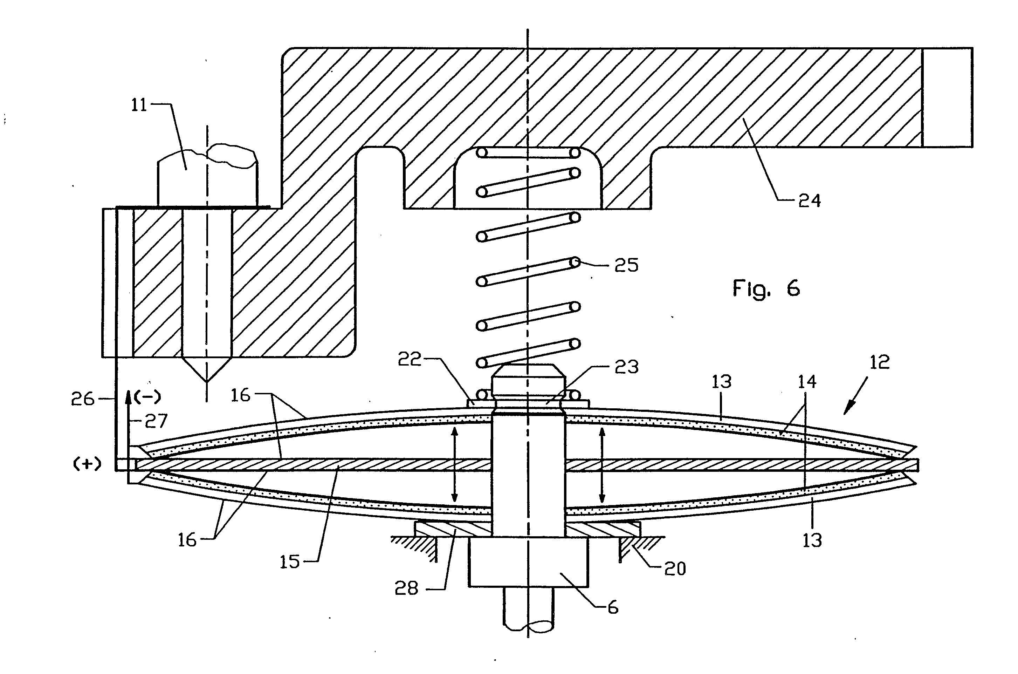

Die Fig. 5 und 6 zeigen eine weitere Ausführungsform der Erfindung. Bei dieser Ausführungsform sitzen die Keramikplatten 14 auf entgegengesetzten Seiten einer Verbundfolie aus einer Isolierfolie 15 mit zwei Leiterfolien 16. Die beiden Leiterfolien 16 führen zu Anschlußfahnen 26, die an den Anschlußsteg 11 angeschlossen sind. Auf der jeweiligen Trägerplatte 13 liegt ebenfalls eine Leiterfolie 16. Diese Leiterfolien sind zu Anschlußfahnen 27 geführt. Eine Keramikplatte 14 stützt sich an der Federscheibe 22 ab. Die andere Keramikplatte 14 stützt sich an einer Isolierplatte 28 ab, die an einer Schulter 20 des Ventilgehäuses anliegt.

Die Funktion dieses Kraftstoffeinspritzventiles entspricht im wesentlichen der zuvor beschriebenen Ausführungsform nach den Fig. 3 und 4. Fig. 5 zeigt den Grundzustand des Kraftstoffeinspritzventiles, Fig. 6 den Erregungszustand, in dem das Ventil geöffnet ist. Dabei sind die Keramikplatten konkav gewölbt.

## Ansprüche

1. Kraftstoffeinspritzventil mit einem piezokeramischen Ventilkörper umfassend aufeinander geschichtete Keramikplatten mit Spannungszuführungen zu jeder Keramikplatte, wobei jede Keramikplatte auf einer Trägerplatte sitzt, wobei jeweils zwischen benachbarten Träger-Keramikplatten Leiterfolie angeordnet ist und jeweils Anschlußfahnen der Leiterfolien mit verschiedenen Kontakten verbunden sind, dadurch gekennzeichnet, daß jeweils paarweise Träger-Keramikplatten entgegengesetzer Polarität aufeinander geschichtet sind.

2. Kraftstoffeinspritzventil nach Anspruch 1, dadurch gekennzeichnet, daß die Träger-Keramikplatten eines jeden Paares bei Anlegung einer Erregungsspannung konvex zueinander gekrümmt sind und sich im Mittelbereich unmittelbar aneinander abstützen.

3. Kraftstoffeinspritzventil nach Anspruch 2, dadurch gekennzeichnet, daß zwischen den Träger-Keramikplatten eines jeden Paares ein Metallring angeordnet ist, auf dem sich die Träger-Keramikplatten einerseits abstützen und der andererseits einen Anschlußkontakt für das Träger-Keramikplattenpaar aufweist.

4. Kraftstoffeinspritzventil nach Anspruch 2 oder 3, dadurch gekennzeichnet, daß die Randbereiche der Träger-Keramikplatten jeweils auf einer Platte (17, 18) abgestützt sind, die die Ventilbewegung auf den Verschlußkörper überträgt.

5. Kraftstoffeinspritzventil nach Anspruch 1, dadurch gekennzeichnet, daß die Träger-Keramikplatten eines jeden Paares bei Anlegung einer Erregungsspannung konkav zueinander gekrümmt sind und sich jeweils am Rand gegeneinander abstützen.

Fig. 1

Fig. 2

Fig. 3

Fig. 4

EP 0 323 638 A1

Fig. 5

EP 0 323 638 A1

Fig. 6

EP 0 323 638 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y,D | DE-A-3 532 660 (ATLAS) <br> * Insgesamt * | 1,5 | F 02 M 51/06 <br> H 01 L 41/08 |
| A | | 2-4 | |
| | --- | | |
| Y | NACHRICHTENTECHNIK ELEKTRONIK, Jrg. 27, Nr. 9, 1977, Seiten 381-383, Berlin, DE; P. KUNATH et al.: "Einsatz piezoelektrischer Bauelemente in elektromechanischen Stellgliedern" <br> * Seiten 382,383; Figur 7 * | 1,5 | |
| A | IDEM | 2 | |
| | --- | | |
| A | DE-A-2 848 812 (DAIMLER-BENZ) <br> * Seite 3, Zeile 19 - Seite 4, Zeile 4; Seite 5 - Seite 7, Zeile 28; Figur * | 1,5 | |
| | ------ | | |

| | RECHERCHIERTE SACHGEBIETE (Int. Cl.4) |
|---|---|
| | F 02 M <br> F 16 K <br> H 01 L |

Der vorliegende Recherchenbericht wurde für alle Patentansprüche erstellt

| Recherchenort | Abschlußdatum der Recherche | Prüfer |
|---|---|---|
| DEN HAAG | 05-04-1989 | ERNST J.L. |

EPO FORM 1503 03.82 (P0403)